# EUROPEAN PATENT APPLICATION

(11) **EP 4 733 991 A1**
(43) Date of publication of application: **29.04.2026**
(21) Application number: 25176791.9
(22) Date of filing: 15.05.2025
(51) Int. Cl.: G06N 3/0455, G06F 13/16, H03M 7/30

(54) **MEMORY DEVICE FOR PERFORMING ASYMMETRIC COMPRESSION AND DECOMPRESSION AND OPERATING METHOD THEREOF**

(30) Priority: 23.10.2024 KR 20240145947; 17.03.2025 KR 20250034166
(71) Applicant: Samsung Electronics Co., Ltd., Suwon-si, Gyeonggi-do 16677 (KR)
(72) Inventor: JEE, Seunghoon, 16678 Suwon-Si (KR); OH, Dokwan, 16678 Suwon-Si (KR); OH, Paul, 16678 Suwon-Si (KR); LEE, Junhee, 16678 Suwon-Si (KR); HWANG, Chansol, 16678 Suwon-Si (KR)
(74) Representative: Marks & Clerk LLP

(57) **Abstract**

A memory controller includes one or more processors including processing circuitry, and a memory storing instructions. The instructions, when executed by the one or more processors individually or collectively, cause the memory controller to generate latent data representations corresponding to data values to be written in a memory space by using an invertible neural network model, generate distribution parameters corresponding to the latent data representations by using a non-invertible neural network model, compress the latent data representations based on the distribution parameters, partially decompress at least one latent data representation from among the compressed latent data representations corresponding to at least one data value from among the data values written in the memory space, based on a command from a host device to provide the at least one data value, and provide, to the host device, the at least one data value.

## Description

### BACKGROUND

### 1. FIELD

The present disclosure relates generally to memory devices, and more particularly, to a memory device for performing asymmetric compression and decompression and an operating method thereof.

### 2. DESCRIPTION OF THE RELATED ART

A compute express link (CXL) may refer to a relatively high-speed interconnect technology that may be used for relatively high-performance computing. A CXL may provide a relatively fast transmission environment between devices, such as, but not limited to, a processor, a memory, or an accelerator. A CXL-based memory may provide a capability to compress and/or store data.

Deep learning-based neural networks may have been recently applied to various fields, such as, but not limited to, data compression. The deep learning-based neural networks may be trained based on deep learning and may perform inference for a desired purpose by mapping input data and output data that may have a nonlinear relationship to each other. Such a trained capability of generating the mapping may be referred to as a learning ability of the deep learning-based neural network.

### SUMMARY

According to an aspect of the present disclosure, a memory controller includes one or more processors including processing circuitry, and a memory storing instructions. The instructions, when executed by the one or more processors individually or collectively, cause the memory controller to generate latent data representations corresponding to data values to be written in a memory space by using an invertible neural network model, generate distribution parameters corresponding to the latent data representations by using a non-invertible neural network model, compress the latent data representations based on the distribution parameters, partially decompress at least one latent data representation from among the compressed latent data representations corresponding to at least one data value from among the data values written in the memory space, based on a command from a host device to provide the at least one data value, and provide, to the host device, the at least one data value.

During an operation of a memory device in response to a write request and read request of a processor, the data size of the write request may be asymmetric to the data size of the read request. Despite this asymmetry, the memory device may compress relatively large-sized data of the write request and/or may perform partial decompression for relatively small-sized data of the read request. If the small-sized data of the read request is obtained from the decompressed data after decompressing all the large-sized compressed data of the write request, a processing speed may not be fast enough for the read request. The processing speed for the read request may be directly related to the processing speed of the processor. Thus, a slow processing speed for the read request may critically affect the processing performance of the processor. By making it so that the memory device may provide the data value to the processor by performing partial decompression and responding to the read request relatively quickly (e.g., within a timing threshold), the memory device may process the read request relatively quickly by potentially reducing throughput for processing the read request.

According to an aspect of the present disclosure, a memory device includes a memory array configured to store compressed data values, one or more processors including processing circuitry, and a memory storing instructions. The instructions, when executed by the one or more processors individually or collectively, cause the memory device to generate latent data representations corresponding to data values by performing domain conversion such that an entropy of the data values to be written in a memory space is reduced, by using an invertible neural network model, generate distribution parameters corresponding to the latent data representations by using a non-invertible neural network model, generate the compressed data values by performing entropy coding on the latent data representations based on the distribution parameters, based on receiving, from a host device, a read request to read a first data value from among the data values, generate a first latent data representation from among the latent data representations by decompressing a first compressed data value from among the compressed data values, based on a first distribution parameter corresponding to the first data value from among the distribution parameters, generate the first data value corresponding to the first latent data representation by using the invertible neural network model, and provide, to the host device, the first data value.

According to an aspect of the present disclosure, an operating method of a memory controller includes generating latent data representations corresponding to data values to be written in a memory space by using an invertible neural network model, generating distribution parameters corresponding to the latent data representations by using a non-invertible neural network model, compressing the latent data representations based on the distribution parameters, partially decompressing at least one latent data representation from among the compressed latent data representations corresponding to at least one data value from among the data values written in the memory space, based on a command from a host device to provide the at least one data value, and provide, to the host device, the at least one data value.

Additional aspects may be set forth in part in the description which follows and, in part, may be apparent from the description, and/or may be learned by practice of the presented embodiments.

Further advantages, features, and aspects of memory device embodiments according to the present disclosure are defined by the following set of clauses:
1. A memory device, comprising:
   a memory array configured to store compressed data values;
   one or more processors comprising processing circuitry; and
   a memory storing instructions,
   wherein the instructions, when executed by the one or more processors individually or collectively, cause the memory device to:
      generate latent data representations corresponding to data values by performing domain conversion such that an entropy of the data values to be written in a memory space is reduced, by using an invertible neural network model;
      generate distribution parameters corresponding to the latent data representations by using a non-invertible neural network model;
      generate the compressed data values by performing entropy coding on the latent data representations based on the distribution parameters;
      based on receiving, from a host device, a read request to read a first data value from among the data values, generate a first latent data representation from among the latent data representations by decompressing a first compressed data value from among the compressed data values, based on a first distribution parameter corresponding to the first data value from among the distribution parameters;
      generate the first data value corresponding to the first latent data representation by using the invertible neural network model; and
      provide, to the host device, the first data value.
2. The memory device of clause 1, wherein the read request comprises a first index value indicating the first data value, and
   wherein the instructions, when executed by the one or more processors individually or collectively, further cause the memory device to select the first distribution parameter from among the distribution parameters based on the first index value.
3. The memory device of clause 1, wherein the instructions, when executed by the one or more processors individually or collectively, further cause the memory device to:
   generate merged data representations by reshaping the latent data representations; and
   generate respective distribution parameters of the latent data representations based on a distribution of the merged data representations.

### BRIEF DESCRIPTION OF THE DRAWINGS

The above and other aspects, features, and advantages of certain embodiments of the present disclosure may be more apparent from the following description taken in conjunction with the accompanying drawings, in which:
FIG. 1 is a diagram illustrating an example of an operation of a memory device in response to a write request and read request of a processor, according to an embodiment;
FIG. 2 is a diagram illustrating an example of a configuration of a memory device, according to an embodiment;
FIG. 3 is a diagram illustrating an example of a data compression process based on an invertible neural network model and a non-invertible neural network model, according to an embodiment;
FIG. 4 is a diagram illustrating an example of a data flow in a compression process, according to an embodiment;
FIG. 5 is a diagram illustrating an example of a process of generating distribution parameters, according to an embodiment;
FIG. 6 is a diagram illustrating an example of a data decompression process based on an invertible neural network model and a non-invertible neural network model, according to an embodiment;
FIG. 7 is a diagram illustrating an example of a data flow in a decompression process, according to an embodiment;
FIG. 8 is a diagram illustrating an example of a process of extracting distribution parameters, according to an embodiment;
FIG. 9 is a diagram illustrating an example of an operating method of a memory controller, according to an embodiment; and
FIG. 10 is a diagram illustrating an example of a configuration of an electronic device, according to an embodiment.

### DETAILED DESCRIPTION

The following structural and/or functional descriptions are provided as an example only and various alterations and modifications may be made to embodiments. As used herein, examples may not be construed as limiting to the disclosure and may be understood to include all changes, equivalents, and replacements within the idea and the technical scope of the disclosure.

Terms, such as first, second, or the like, may be used herein to describe various components. Each of these terminologies is not used to define an essence, order, or sequence of a corresponding component but may be used merely to distinguish the corresponding component from other components. For example, a first component may be referred to as a second component, and similarly, the second component may also be referred to as the first component.

It is to be understood that if a component is described as being "connected", "coupled", and/or "joined" to another component, a third component may be "connected", "coupled", and/or "joined" between the first and second components, although the first component may be directly connected, coupled, and/or joined to the second component.

The singular forms "a", "an", and "the" may be intended to include the plural forms as well, unless the context clearly indicates otherwise. It is to be further understood that the terms "comprises/comprising" and/or "includes/including" when used herein, may specify the presence of stated features, integers, steps, operations, elements, and/or components, but may not preclude the presence and/or addition of one or more other features, integers, steps, operations, elements, components and/or groups thereof.

As used herein, "at least one of A and B", "at least one of A, B, or C," or the like, each of which may include any one of the items listed together in the corresponding one of the phrases, or all possible combinations thereof.

Unless otherwise defined, all terms, including technical and scientific terms, used herein may have the same meaning as commonly understood by one of ordinary skill in the art to which this disclosure pertains. Terms, such as those defined in commonly used dictionaries, are to be interpreted as having a meaning that may be consistent with their meaning in the context of the relevant art and may not be interpreted in an idealized or overly formal sense unless expressly so defined herein.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

It is to be understood that the specific order or hierarchy of blocks in the processes/flowcharts disclosed are an illustration of exemplary approaches. Based upon design preferences, it is understood that the specific order or hierarchy of blocks in the processes/flowcharts may be rearranged. Further, some blocks may be combined or omitted. The accompanying claims present elements of the various blocks in a sample order, and are not meant to be limited to the specific order or hierarchy presented.

The embodiments herein may be described and illustrated in terms of blocks, as shown in the drawings, which carry out a described function or functions. These blocks, which may be referred to herein as units or modules or the like, or by names such as device, logic, circuit, controller, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

Hereinafter, embodiments are described with reference to the accompanying drawings. When describing the embodiments with reference to the accompanying drawings, like reference numerals refer to like elements, and a repeated description related thereto may be omitted for the sake of brevity.

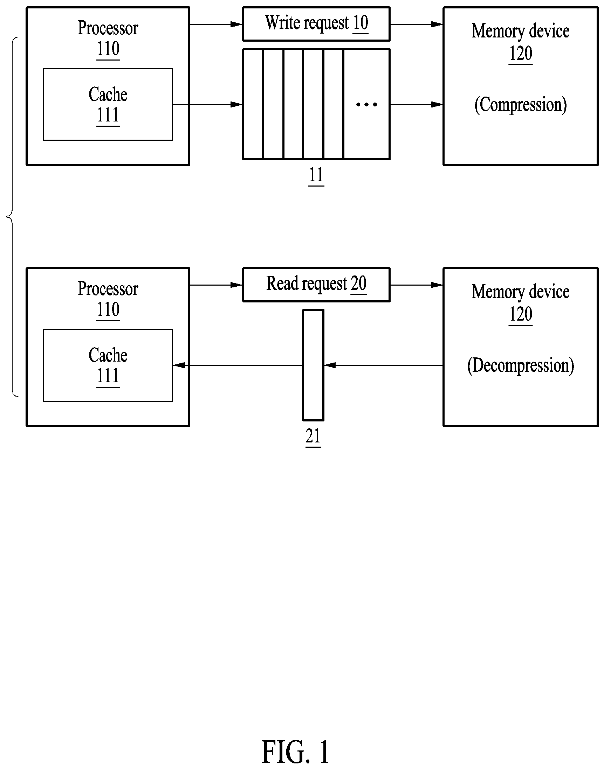

FIG. 1 is a diagram illustrating an example of an operation of a memory device in response to a write request and read request of a processor, according to an embodiment. Referring to FIG. 1, a processor 110 may transmit a write request 10 for data values 11 of a cache 111 to be written in a memory device 120 to the memory device 120. The memory device 120 may store the data values 11 in a memory space of the memory device 120 in response to the write request 10 of the processor 110. The memory device 120 may compress the data values 11 and store the data values 11 in the memory space. Data compression may enable the efficient use of the memory space.

If a data value 21 from among the data values 11 is required, the processor 110 may transmit a read request 20 for the data value 21 to be read from the memory device 120 to the memory device 120. The data value 21 may be a part of the data values 11. For example, the size of the data values 11 may be 4 kilobytes (KB), and the size of the data value 21 may be 64 bytes (B), however, the present disclosure is not limited thereto. For example, the size of the data values 11 stored in the memory device 120 and/or the size of the data value 21 may vary within the scope of present disclosure.

The memory device 120 may obtain the data value 21 by performing decompression on a compressed data value of the data value 21 from among compressed data values of the data values 11. To obtain the data value 21, partial decompression may be performed on the compressed data values. The memory device 120 may transmit the data value 21 to the processor 110. The processor 110 may store the data value 21 in the cache 111.

The data size (e.g., 4 KB) of the write request 10 may be asymmetric to the data size (e.g., 64 B) of the read request 20. Despite this asymmetry, the memory device 120 may compress relatively large-sized data of the write request 10 and/or may perform partial decompression for relatively small-sized data of the read request 20. In an embodiment, if the small-sized data of the read request 20 is obtained from the decompressed data after decompressing all the large-sized compressed data of the write request 10, a processing speed may not be fast enough for the read request 20. The processing speed for the read request 20 may be directly related to the processing speed of the processor 110. Thus, a slow processing speed for the read request 20 may critically affect the processing performance of the processor 110.

In an embodiment, the memory device 120 may provide the data value 21 to the processor 110 by performing partial decompression and responding to the read request 20 relatively quickly (e.g., within a timing threshold). Moreover, as described below, the memory device 120 may process the read request 20 relatively quickly by potentially reducing throughput for processing the read request 20.

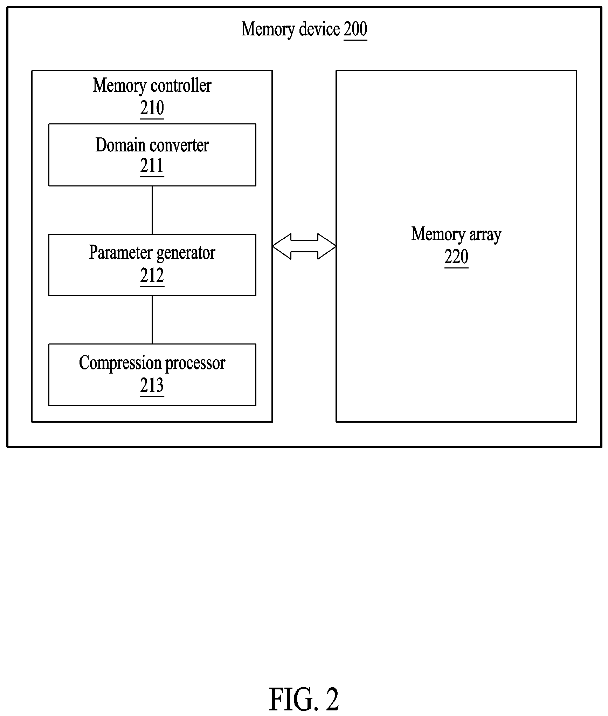

FIG. 2 is a diagram illustrating an example of a configuration of a memory device, according to an embodiment. Referring to FIG. 2, the memory device 200 may include a memory controller 210 and a memory array 220. The memory controller 210 may compress data values of a write request and may store the compressed data values in a memory space of the memory array 220. Alternatively or additionally, the memory controller 210 may decompress a compressed data value corresponding to a data value of a read request. The memory array 220 may include the memory space. The memory array 220 may store the compressed data values in the memory space.

The memory controller 210 may include a domain converter 211, a parameter generator 212, and a compression processor 213. The domain converter 211, the parameter generator 212, and/or the compression processor 213 may be implemented as digital circuits separate from the memory controller 210 and/or may be incorporated into the memory controller 210. In an embodiment, the domain converter 211, the parameter generator 212, and/or the compression processor 213 may be physically implemented by analog and/or digital circuits including one or more of a logic gate, an integrated circuit, a microprocessor, a microcontroller, a memory circuit, a passive electronic component, an active electronic component, an optical component, or the like. For example, a field programmable gate array (FPGA) may be used to implement custom logic that may include the functionality of at least one of the domain converter 211, the parameter generator 212, or the compression processor 213. As another example, a processor in combination with a memory may be used to execute one or more instructions to perform the functionality of at least one of the domain converter 211, the parameter generator 212, or the compression processor 213. Alternatively or additionally, at least a portion of the functionality of at least one of the domain converter 211, the parameter generator 212, or the compression processor 213 may be incorporated into the memory controller 210 and/or may be implemented as instructions to be executed by the memory controller 210.

In response to receiving the write request for the data values to be written in the memory space, the domain converter 211 may generate latent data representations corresponding to the data values by using an invertible neural network model. The parameter generator 212 may generate distribution parameters corresponding to the latent data representations by using a non-invertible neural network model. The compression processor 213 may compress the latent data representations based on the distribution parameters. The memory array 220 may store compressed latent data representations in the data space of the memory array 220.

The domain converter 211 may generate the latent data representations by performing domain conversion such that the entropy of the data values is reduced by using the domain conversion model. In an example, the domain conversion model may be implemented as hardware (e.g., analog and/or digital circuits, a microprocessor, a microcontroller, a memory circuit, or the like). For example, network parameters of the domain conversion model may be stored as parameter values of a network operator. The domain conversion model may perform a hardware-based network operation based on an input of the data values and may generate the latent data representations.

The domain conversion model may include neural network-based coupling layers. The coupling layers may perform the same type of domain conversion and/or may perform different types of domain conversion. A coupling layer from among the coupling layers may divide input data into first sub-data and second sub-data, may generate first processed sub-data by processing the first sub-data, and generate output data by combining the first processed sub-data with the second sub-data. The input data may be the data values of the write request, and the output data may be the latent data representations corresponding to the data values.

The coupling layer may process the first sub-data by using neural network-based processing layers. The processing layers may process the first sub-data by using trained network parameters, and a processing result may be quantized to be combined with the second sub-data. The data values of the write request may perform domain conversion on the data values of the write request while passing through the coupling layers.

The processing layers may be trained to perform domain conversion such that the entropy of the data values may be reduced by using the network parameters. The network parameters of the processing layers may include a division ratio parameter and/or a selection parameter. The processing layers may extract the first sub-data and the second sub-data from the input data by using the division ratio parameter and/or the selection parameter. The network parameters of the processing layers may be determined in a training process of the coupling layer.

In an embodiment, the invertible neural network model may include a normalizing flow. The invertible neural network model may sequentially convert the input data by using layers to generate the output data. The layers may sequentially process the output data based on the invertible characteristics of the invertible neural network model to generate the input data. These invertible characteristics may be used for lossless compression.

The invertible neural network model may be configured to meet a relatively high level of compression performance constraints to provide the invertible characteristics. The invertible neural network model may need to include a relatively large number of layers in order to potentially achieve the high compression performance constraints. However, as the number of layers increases, the time incurred for compression and decompression may also increase. According to an embodiment, by limiting the number of layers of the invertible neural network model and using small-sized input data and a non-invertible neural network model, compression performance may be improved when compared to a related invertible neural network model. For example, the non-invertible neural network model may estimate a probability distribution of the generated latent data representations by using the invertible neural network model. Based on the probability distribution estimated by the non-invertible neural network model, the bit allocation of the latent data representations may be optimized, and a compression rate may be improved, when compared to a related memory device.

The parameter generator 212 may generate the distribution parameters corresponding to the latent data representations by using the non-invertible neural network model. The distribution parameters may be and/or may include the probability distribution of the latent data representations. For example, the probability distribution may be a Gaussian distribution or a Laplacian distribution. However, the present disclosure is not limited in this regard. The distribution parameters may include mean and standard deviation.

The parameter generator 212 may include the parameter detection model, an entropy coder, and an entropy decoder. According to an embodiment, the non-invertible neural network model may include a variational autoencoder (VAE). For example, the non-invertible neural network model may include a hyper prior.

The non-invertible neural network model may include a hyper encoder and a hyper decoder. The hyper encoder may encode the latent data representations to generate hyper latent data representations. The entropy coder may perform entropy coding on the hyper latent data representations by using a trained probability distribution. For example, the probability distribution may be obtained through Gaussian modeling based on trained parameters, however, the present disclosure is not limited thereto. Arithmetic coding may be used for entropy coding, however, the present disclosure is not limited thereto. The coded hyper latent data representations may be generated according to the entropy coding.

The entropy decoder may perform entropy decoding on the coded hyper latent data representations by using the trained probability distribution. The restored hyper latent data representations may be generated according to the entropy decoding. Arithmetic decoding may be used for entropy decoding, however, the present disclosure is not limited thereto. The hyper decoder may decode the restored hyper latent data representations to generate the distribution parameters of the latent data representations. The distribution parameters may be and/or may include feature vectors that express the latent data representations as a probability distribution. To quickly process the read request (e.g., within a timing threshold), the number of layers of the hyper decoder may be less than the number of layers of the hyper encoder. For example, the number of layers of the hyper encoder may be five (5), and the number of layers of the hyper decoder may be one or two (2), however, the present disclosure is not limited thereto.

In an embodiment, the parameter detection model may be implemented as hardware (e.g., analog and/or digital circuits, a microprocessor, a microcontroller, a memory circuit, or the like). For example, the network parameters of the parameter detection model may be stored as the parameter values of a network operator. The parameter detection model may perform a hardware-based network operation based on an input of the latent data representations and may generate latent data distribution parameters.

The compression processor 213 may compress the latent data representations based on the distribution parameters. The compression processor 213 may include an entropy coder and an entropy decoder. The entropy coder and entropy decoder of the compression processor 213 may be different from the entropy coder and entropy decoder of the parameter generator 212. The entropy coder and entropy decoder of the compression processor 213 may be respectively referred to as a first entropy coder and a first entropy decoder, and the entropy coder and entropy decoder of the parameter generator 212 may be respectively referred to as a second entropy coder and a second entropy decoder. In an embodiment, the first and second entropy coders and the first and second entropy decoders may be implemented as hardware (e.g., analog and/or digital circuits, a microprocessor, a microcontroller, a memory circuit, or the like).

The compression processor 213 may perform entropy coding on the latent data representations based on the distribution parameters. The compression processor 213 may perform entropy coding by using the first entropy coder. The compressed data values may be generated as a result of the entropy coding. For example, the compressed data values may be and/or may include coded data values.

In an embodiment, partial decompression may be performed in response to the read request from a processor. The processor may transmit the read request with a specified data value to be read, and partial decompression may be performed on the specified data value. For example, in response to the read request to read a first data value from among the data values of the write request, the first data value may be generated from a first compressed data value from among the compressed data values of the latent data representations by using a first distribution parameter corresponding to the first data value from among the distribution parameters. The first data value of the read request may be a part of the data values of the write request. For example, the size of the data values may be 4 KB, and the size of the first data value may be 64 B, however, the present disclosure is not limited thereto. The compressed data values of the latent data representations may be values coded by the first entropy coder based on the latent data representations and the distribution parameters.

In response to receiving the read request to read the first data value from among the data values, the compression processor 213 may generate a first latent data representation by decompressing the first compressed data value from among the compressed data values of the latent data representations, based on the first distribution parameter corresponding to the first data value from among the distribution parameters. As described below, the distribution parameters corresponding to the data values may be independently generated. The data values may be independently compressed by using independent distribution parameters. The first distribution parameter corresponding to the first data value from among the independent distribution parameters may be selectively used for partial decompression of the first compressed data value.

The domain converter 211 may generate the first data value corresponding to a first latent data representation by using the domain conversion model. A first decompressed data may be the first latent data representation. The domain conversion model may generate the latent data representations by performing domain conversion on the data values and may generate the data values by performing domain inverse conversion on the latent data representations. The domain conversion model may generate the first data value by performing partial domain inverse conversion on the first latent data representation from among the latent data representations. Domain conversion may refer to forward domain conversion and domain inverse conversion may refer to backward domain conversion. The domain conversion model may perform forward and/or backward domain conversion based on the invertible characteristics.

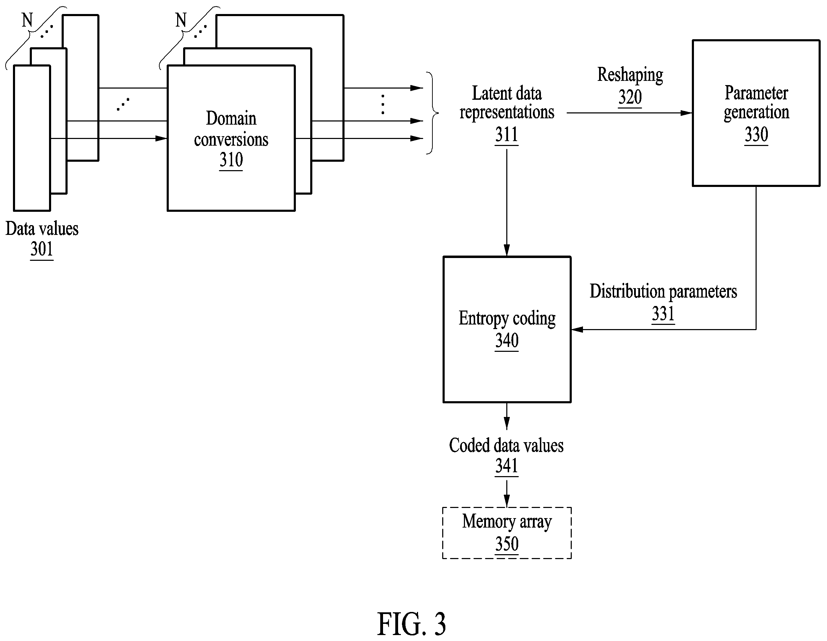

FIG. 3 is a diagram illustrating an example of a data compression process based on an invertible neural network model and a non-invertible neural network model, according to an embodiment. Referring to FIG. 3, based on domain conversions 310 related to data values 301, latent data representations 311 may be generated. The domain conversions 310 may be performed by using an invertible neural network model. The number of the data values 301 may be N, where N is a positive integer greater than zero (0). For example, if a write request for 4 KB data values 301 is received, each of the data values 301 may be 64 B, and N may be 64, however, the present disclosure is not limited thereto.

N domain conversions 310 may be performed on the N data values 301. N domain conversions 310 may be independently performed. N domain conversions 310 may be sequentially performed by using a single domain conversion model, and/or N domain conversions 310 may be performed in parallel by using N sub-models of a domain conversion model. The sub-models may have independent network parameters and/or may share network parameters. The number of latent data representations 311 generated, according to N domain conversions 310, may be N.

As described above, the invertible neural network model may be designed to meet a relatively high level of compression performance constraints to provide the invertible characteristics. According to an embodiment, the number of layers of the invertible neural network model may be limited, however, N domain conversions 310 may be independently performed on N data values 301. For example, instead of performing one (1) domain conversion on integrated N data values 301, independent N domain conversions 310 may be performed on N data values 301. Accordingly, the limited expressiveness of the invertible neural network model may be compensated.

As described above, by limiting the number of layers of the invertible neural network model and/or by using a non-invertible neural network model, compression performance may be improved, when compared to a related memory device. Based on a reshaping operation 320 of the latent data representations 311, a merged latent data representation may be generated. Based on the reshaping operation 320, the latent data representations 311 may be merged. The number of the latent data representations 311 may be N, and the number of reshaped latent data representations may be one (1), however, the present disclosure is not limited thereto. For example, based on the reshaping operation 320 of the latent data representations 311, M merged latent data representations may be generated. M may be a positive integer greater than one (1) and less than N (e.g., 1 < M < N).

Respective distribution parameters of the latent data representations 311 may be generated by performing parameter generation 330 based on a distribution of the merged latent data representation. Parameter generation 330 may be performed by using a parameter generator including a non-invertible neural network model. The parameter generator may generate the respective distribution parameters of the latent data representations 311 by predicting respective probability distributions of the latent data representations 311 based on the distribution of the merged latent data representation. The parameter generator (e.g., a parameter generation model) may be trained to predict the respective probability distributions of the latent data representations 311 based on the distribution of the merged latent data representation. As the range of input data may be wider, the accuracy of distribution prediction may be better, when compared to a related invertible neural network model. When using the distribution of the merged latent data representation, the accuracy of distribution parameters 331 may be improved compared to using the respective distributions of the latent data representations 311.

Based on the latent data representations 311 and the distribution parameters 331, entropy coding 340 may be performed. Coded data values 341, according to entropy coding 340, may be generated. The coded data values 341 may be stored in a memory array 350. The memory array 350 may include and/or may be similar in many respects to the memory array 220 described above with reference to FIG. 2, and may include additional features not mentioned above. Consequently, repeated descriptions of the memory array 350 described above with reference to FIG. 2 may be omitted for the sake of brevity.

Entropy coding 340 may be performed by using a first entropy coder. The latent data representations 311 may correspond one-to-one to the distribution parameters 331. The latent data representations 311 and the distribution parameters 331 may have data pairs having a one-to-one correspondence. For example, the distribution parameters 331 may include a first distribution parameter indicating a probability distribution of a first latent data representation from among the latent data representations 311. In this case, the first latent data representation and the first distribution parameter may form a first corresponding pair.

The first entropy coder may generate the coded data values 341 by performing entropy coding on each of the corresponding pairs. The data values 301 may correspond one-to-one to the coded data values 341. For example, the coded data values 341 may include a first coded data value corresponding to a first data value from among the data values 301.

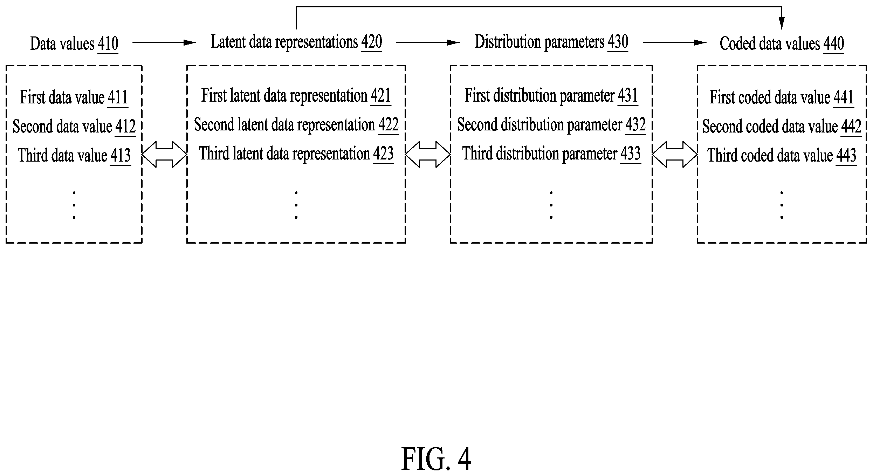

FIG. 4 is a diagram illustrating an example of a data flow in a compression process, according to an embodiment. Referring to FIG. 4, latent data representations 420 (e.g., a first latent data representation 421, a second latent data representation 422, and a third latent data representation 423) respectively corresponding to data values 410 (e.g., a first data value 411, a second data value 412, and a third data value 413) may be generated based on domain conversions, distribution parameters 430 (e.g., a first distribution parameter 431, a second distribution parameter 432, and a third distribution parameter 433) respectively corresponding to the latent data representations 420 may be generated based on parameter generation, and coded data values 440 (e.g., a first coded data value 441, a second coded data value 442, and a third coded data value 443) respectively corresponding to the latent data representations 420 and the distribution parameters 430 may be generated based on entropy coding.

The data values 410, the latent data representations 420, the distribution parameters 430, and the coded data values 440 may have a one-to-one correspondence with one another. For example, the first latent data representation 421 may be generated based on the first data value 411, the first distribution parameter 431 may be generated based on the first latent data representation 421, and the first coded data value 441 may be generated based on the first latent data representation 421 and the first distribution parameter 431. As another example, the second latent data representation 422 may be generated based on the second data value 412, the second distribution parameter 432 may be generated based on the second latent data representation 422, and the second coded data value 442 may be generated based on the second latent data representation 422 and the second distribution parameter 432. As yet another example, the third latent data representation 423 may be generated based on the third data value 413, the third distribution parameter 433 may be generated based on the third latent data representation 423, and the third coded data value 443 may be generated based on the third latent data representation 423 and the third distribution parameter 433.

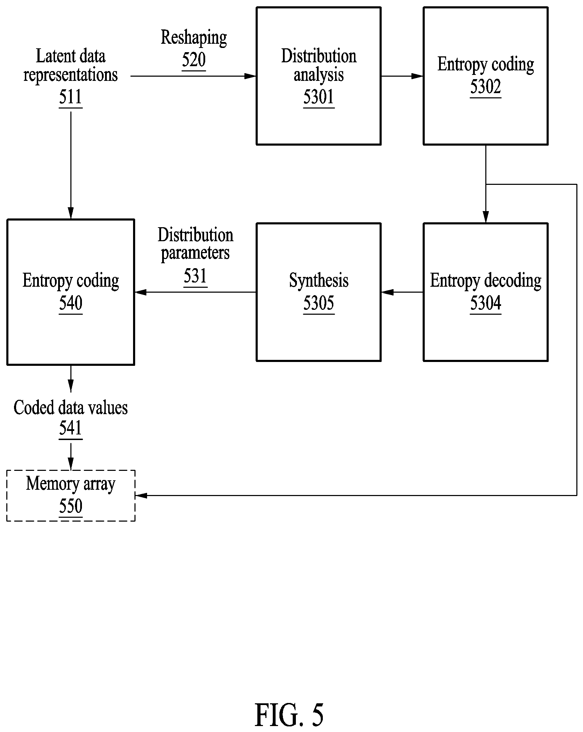

FIG. 5 is a diagram illustrating an example of a process of generating distribution parameters, according to an embodiment. Referring to FIG. 5, based on a reshaping operation 520 of latent data representations 511, a merged latent data representation may be generated. Distribution analysis 5301 may be performed on the merged latent data representation. Distribution analysis 5301 may be performed by using a hyper encoder. Hyper latent data representations may be generated according to distribution analysis 5301. Coded hyper latent data representations may be generated according to entropy coding 5302 of the hyper latent data representations. Entropy coding 5302 may be performed by using a second entropy coder. The coded hyper latent data representations may be stored in a memory array 550.

Based on entropy decoding 5304 of the coded hyper latent data representations, restored hyper latent data representations may be generated. The entropy decoding 5304 may be performed by using a second entropy decoder. Synthesis 5305 may be performed based on the restored hyper latent data representations. Synthesis 5305 may be performed by using a hyper decoder. Distribution parameters 531 may be generated according to synthesis 5305.

Based on entropy coding 540 based on the latent data representations 511 and the distribution parameters 531, coded data values 541 may be generated. The coded data values 541 and the coded hyper latent data representations stored in the memory array 550 may be used to process a subsequent read request. The memory array 550 may include and/or may be similar in many respects to the memory arrays 220 and 350 described above with reference to FIGS. 2 and 3, and may include additional features not mentioned above. Consequently, repeated descriptions of the memory array 550 described above with reference to FIGS. 2 and 3 may be omitted for the sake of brevity.

In an embodiment, the distribution parameters 531 may be stored in the memory array 550. For example, the distribution parameters 531 instead of the coded hyper latent data representations may be stored in the memory array 550. In this case, a read request may be processed based on the coded data values 541 and the distribution parameters 531 stored in the memory array 550. In this case, the processing speed for the read request may be improved, when compared to a related memory device.

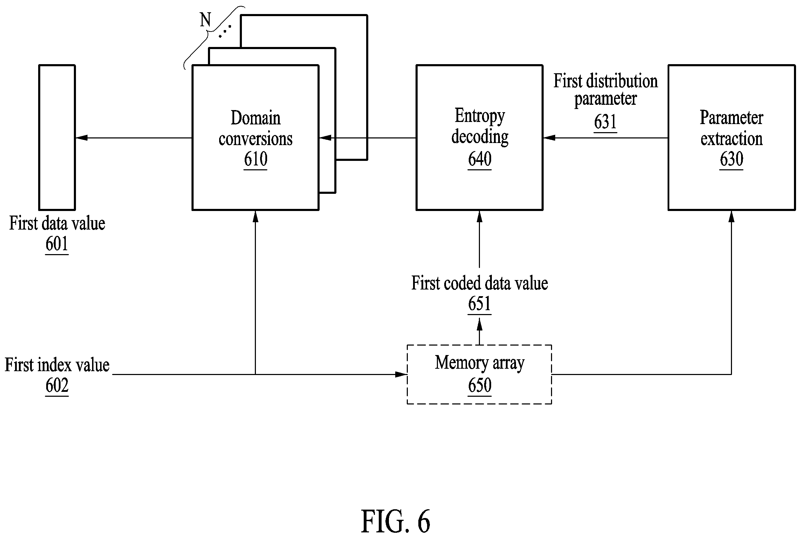

FIG. 6 is a diagram illustrating an example of a data decompression process based on an invertible neural network model and a non-invertible neural network model, according to an embodiment. Referring to FIG. 6, a read request may include a first index value 602 indicating a first data value 601. The first index value 602 may indicate the first data value 601, which may be a part of the data values of a write request. A first distribution parameter 631 may be selectively used from among distribution parameters, based on the first index value 602.

A memory array 650 may store coded hyper latent data representations and/or the distribution parameters. The memory array 650 may include and/or may be similar in many respects to the memory arrays 220, 350, and 550 described above with reference to FIGS. 2, 3, and 5, and may include additional features not mentioned above. Consequently, repeated descriptions of the memory array 650 described above with reference to FIGS. 2, 3, and 5 may be omitted for the sake of brevity.

Based on the first index value 602, a first coded hyper latent data representation corresponding to the first index value 602 from among the coded hyper latent data representations and/or a first distribution parameter 631 corresponding to the first index value 602 from among the distribution parameters may be extracted from the memory array 650. If the first coded hyper latent data representation is extracted, based on parameter extraction 630, the first distribution parameter 631 may be extracted from the first coded hyper latent data representation. Parameter extraction 630 may be performed by using a hyper decoder and a second entropy decoder.

Entropy decoding 640 may be performed based on a first coded data value 651 and the first distribution parameter 631. A first latent data representation may be generated according to the entropy decoding 640. The entropy decoding 640 may be performed by using a first entropy decoder. A first domain conversion corresponding to the first latent data representation from among the domain conversions 610 may be performed. For example, if a domain conversion model includes N sub-models, based on the first index value 602, a first sub-model may be selected from among the sub-models, and the first domain conversion may be performed by using the first sub-model. The first data value 601 may be generated according to the first domain conversion. The first data value 601 may be provided to a processor in response to the read request.

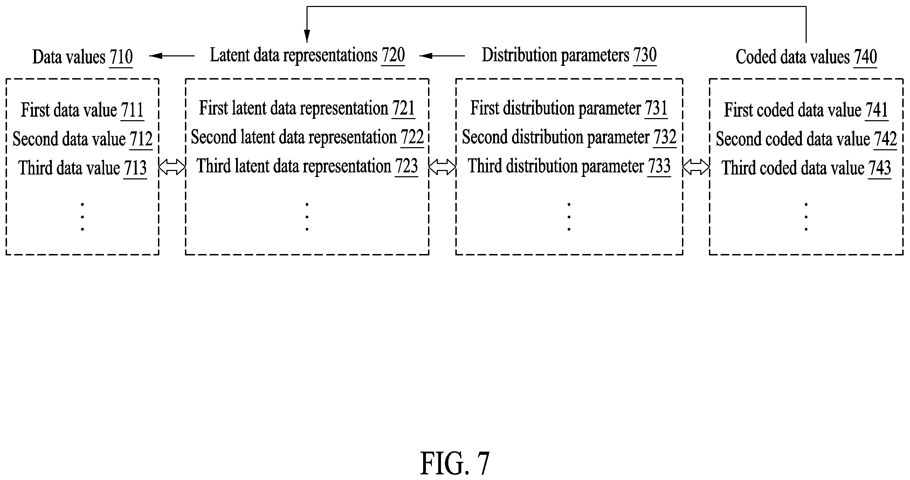

FIG. 7 is a diagram illustrating an example of a data flow in a decompression process, according to an embodiment. Referring to FIG. 7, data values 710 (e.g., a first data value 711, a second data value 712, and a third data value 713), latent data representations 720 (e.g., a first latent data representation 721, a second latent data representation 722, and a third latent data representation 723), distribution parameters 730 (e.g., a first distribution parameter 731, a second distribution parameter 732, and a third distribution parameter 733), and coded data values 740 (e.g., a first coded data value 741, a second coded data value 742, and a third coded data value 743) may have a one-to-one correspondence with one another. For example, the one-to-one correspondence may be formed between the first to third data values 711 to 713 of the data values 710, the first to third latent data representations 721 to 723 of the latent data representations 720, the first to third distribution parameters 731 to 733 of the distribution parameters 730, and the first to third coded data values 741 to 743 of the coded data values 740.

A processor may transmit a read request indicating a part of the data values 710. In this case, the read request may include an index value indicating a part of the data values 710. For example, the read request may include a first index value indicating the first data value 711 from among the data values 710. In this case, the first coded data value 741 may be extracted from a memory array. The first distribution parameter 731 related to the first coded data value 741 may be extracted.

The memory array 650 may store coded hyper latent data representations and/or the distribution parameters 730. If the coded hyper latent data representations are stored in the memory array 650, a first coded hyper latent data representation may be extracted from the memory array 650. Based on a parameter extraction operation related to the first coded hyper latent data representation, the first distribution parameter 731 may be generated. If the distribution parameters 730 are stored in the memory array, the first distribution parameter 731 may be extracted from the memory array. Based on domain inverse conversion based on the first distribution parameter 731 and the first latent data representation 721, the first data value 711 may be generated.

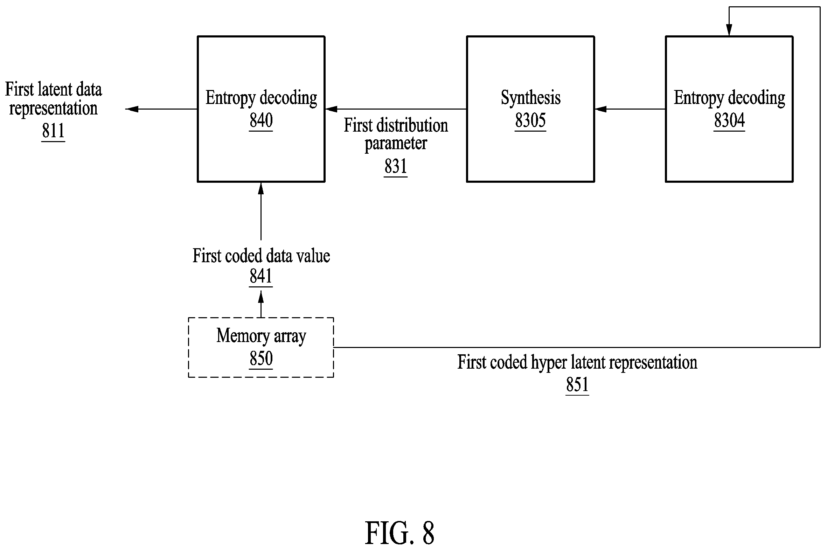

FIG. 8 is a diagram illustrating an example of a process of extracting distribution parameters, according to an embodiment. Referring to FIG. 8, based on a read request for a first data value, a first coded data value 841 and a first coded hyper latent data representation 851 may be extracted from a memory array 850. The memory array 850 may include and/or may be similar in many respects to the memory arrays 220, 350, 550, and 650 described above with reference to FIGS. 2, 3, 5, and 6, and may include additional features not mentioned above. Consequently, repeated descriptions of the memory array 850 described above with reference to FIGS. 2, 3, 5, and 6 may be omitted for the sake of brevity.

According to entropy decoding 8304 of the first coded hyper latent data representation 851, a first restored hyper latent data representation may be generated. Entropy decoding 8304 may be performed by using a second entropy decoder. According to synthesis 8305 related to the first restored hyper latent data representation, a first distribution parameter 831 may be generated. Synthesis 8305 may be performed by using a hyper decoder. Based on entropy decoding 840 related to the first coded data value 841 and the first distribution parameter 831, a first latent data representation 811 may be generated. Entropy decoding 840 may be performed by using a first entropy decoder.

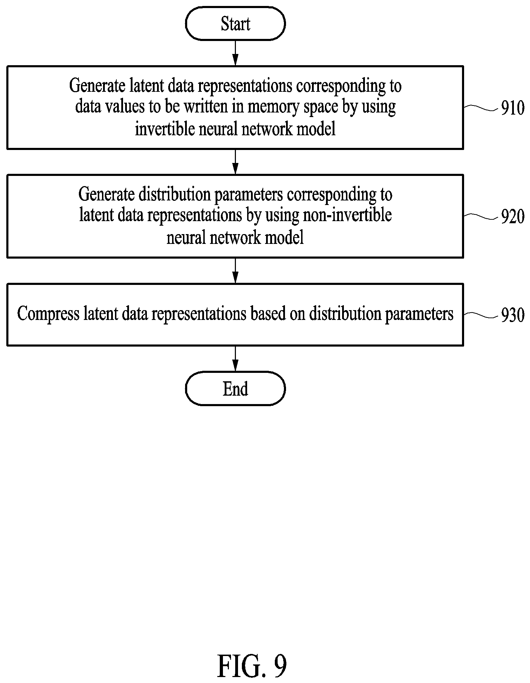

FIG. 9 is a diagram illustrating an example of an operating method of a memory controller, according to an embodiment. Referring to FIG. 9, in operation 910, the memory controller may generate latent data representations corresponding to data values to be written in a memory space by using an invertible neural network model. In operation 920, the memory controller may generate distribution parameters corresponding to the latent data representations by using a non-invertible neural network model. In operation 930, the memory controller may compress the latent data representations based on the distribution parameters.

The memory controller, in response to a read request to read a first data value from among the data values, may generate the first data value from a first compressed data value from among compressed data values of the latent data representations by using a first distribution parameter corresponding to the first data value from among the distribution parameters.

The memory controller, in response to receiving the read request to read the first data value from among the data values, may generate a first latent data representation from among the latent data representations by decompressing the first compressed data value from among the compressed data values of the latent data representations, based on the first distribution parameter corresponding to the first data value from among the distribution parameters.

The memory controller may generate the first data value corresponding to a first latent data representation by using the domain conversion model.

The distribution parameters may be stored in the memory space. The read request may include a first index value indicating the first data value. The first distribution parameter may be selectively used from among the distribution parameters, based on the first index value.

The memory controller may generate the latent data representations by performing domain conversion such that the entropy of the data values is reduced by using the domain conversion model.

The memory controller may perform entropy coding on the latent data representations based on the distribution parameters.

The memory controller may reshape the latent data representations and generate merged latent data representations and may generate respective distribution parameters of the latent data representations based on a distribution of the merged latent data representations.

An invertible neural network model may include a normalizing flow. A non-invertible neural network model may include a VAE.

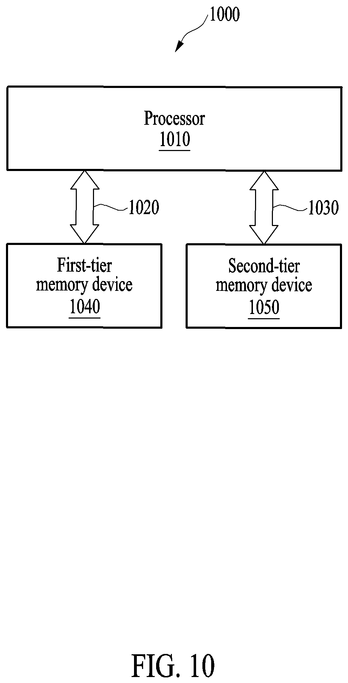

FIG. 10 is a diagram illustrating an example of a configuration of an electronic device, according to an embodiment. Referring to FIG. 10, an electronic device 1000 may include a processor, a first-tier memory device 1040, and a second-tier memory device 1050. The electronic device 1000 may further include additional components, such as, but not limited to, storage (e.g., disk), an input/output (I/O) device, a communication interface, an auxiliary processor (e.g., a graphics processing unit (GPU), a neural processing unit (NPU), or an accelerator), or the like. For example, the electronic device 1000 may be and/or may include a computing device, such as, but not limited to, a desktop computer or a server, however, the present disclosure is not limited thereto. In an embodiment, the processor 1010 may be and/or may include a host processor (e.g., a central processing unit (CPU)). For example, if the electronic device 1000 includes the auxiliary processor, the processor 1010 may be a main processor. According to an embodiment, the second-tier memory device 1050 may be and/or may include a memory device that performs partial decompression based on asymmetric-sized write and read requests.

In an embodiment, the first-tier memory device 1040 may be faster (e.g., faster read and/or write speeds) than the second-tier memory device 1050. In such an embodiment, the second-tier memory device 1050 may provide a larger capacity than the first-tier memory device 1040. For example, the first-tier memory device 1040 may be and/or may include system memory (e.g., dynamic random-access memory (DRAM)), and the second-tier memory device 1050 may be and/or may include additional memory, auxiliary memory, or remote memory, such as, but not limited to, CXL-based memory. The first-tier memory device 1040 may be referred to as fast memory, and the second-tier memory device 1050 may be referred to as slow memory.

The processor 1010 and the first-tier memory device 1040 may be connected through a first interface 1020. For example, the first-tier memory device 1040 may be a DRAM, and the first interface 1020 may be a dual inline memory module (DIMM). The processor 1010 and the second-tier memory device 1050 may be connected through a second interface 1030. For example, the second-tier memory device 1050 may be a CXL-based memory, and the second interface 1030 may be a CXL interface. The first interface 1020 may be different from the second interface 1030. For example, the first interface 1020 and the second interface 1030 may use different communication standards and/or different connection methods.

The processor 1010 may access the first-tier memory device 1040 and the second-tier memory device 1050 by using the first interface 1020 and the second interface 1030, respectively. The processor 1010 may perform memory access by using a memory address. The memory access may include, but not be limited to, a write request and a read request. Data may be stored in a memory space of the memory address according to the write request. Data may be extracted from the memory space upon the read request.

The units described herein may be implemented using a hardware component, a software component and/or a combination thereof. A processing device may be implemented using one or more general-purpose or special-purpose computers, such as, for example, a processor, a controller and an arithmetic logic unit (ALU), a digital signal processor (DSP), a microcomputer, a field-programmable gate array (FPGA), a programmable logic unit (PLU), a microprocessor, or any other device capable of responding to and executing instructions in a defined manner. The processing device may run an operating system (OS) and one or more software applications that run on the OS. The processing unit also may access, store, manipulate, process, and generate data in response to execution of the software. For purpose of simplicity, the description of a processing unit is used as singular, however, one skilled in the art may appreciate that a processing unit may include multiple processing elements and multiple types of processing elements. For example, the processing unit may include a plurality of processors, or a single processor and a single controller. In addition, different processing configurations are possible, such as parallel processors.

The software may include a computer program, a piece of code, an instruction, or some combination thereof, to independently or collectively instruct and/or configure the processing unit to operate as desired. Software and data may be stored in any type of machine, component, physical or virtual equipment, or computer storage medium or device capable of providing instructions or data to or being interpreted by the processing unit. The software also may be distributed over network-coupled computer systems so that the software is stored and executed in a distributed fashion. The software and data may be stored by one or more non-transitory computer-readable recording mediums.

The methods, according to the above-described examples, may be recorded in non-transitory computer-readable media including program instructions to implement various operations of the above-described examples. The media may also include, alone or in combination with the program instructions, data files, data structures, or the like. The program instructions recorded on the media may be those specially designed and constructed for the purposes of examples, or they may be of the kind well-known and available to those having skill in the computer software arts. Examples of non-transitory computer-readable media include magnetic media (e.g., hard disks, floppy disks, and magnetic tape), optical media (e.g., CD-ROM discs and DVDs), magneto-optical media (e.g., optical discs), and hardware devices that may specially configured to store and perform program instructions, (e.g., read-only memory (ROM), RAM, flash memory), or the like. Examples of program instructions include both machine code, such as produced by a compiler, and/or files containing higher-level code that may be executed by the computer using an interpreter.

The above-described devices may act as one or more software modules in order to perform the operations of the above-described examples, or vice versa.

As described above, although the examples have been described with reference to the limited drawings, a person skilled in the art may apply various technical modifications and variations based thereon. For example, suitable results may be achieved if the described techniques are performed in a different order and/or if components in a described system, architecture, device, or circuit are combined in a different manner and/or replaced or supplemented by other components or their equivalents.

Accordingly, other implementations are within the scope of the following claims.

## Claims

1. A memory controller, comprising:
one or more processors comprising processing circuitry; and
a memory storing instructions,
wherein the instructions, when executed by the one or more processors individually or collectively, cause the memory controller to:
generate latent data representations corresponding to data values to be written in a memory space by using an invertible neural network model;
generate distribution parameters corresponding to the latent data representations by using a non-invertible neural network model;
compress the latent data representations based on the distribution parameters;
partially decompress at least one latent data representation from among the compressed latent data representations corresponding to at least one data value from among the data values written in the memory space, based on a command from a host device to provide the at least one data value; and
provide, to the host device, the at least one data value.

2. The memory controller of claim 1, wherein the instructions, when executed by the one or more processors individually or collectively, further cause the memory controller to:
based on the command comprising a read request to read a first data value from among the data values, generate the first data value from a first compressed data value from among compressed data values of the latent data representations by using a first distribution parameter from among the distribution parameters and corresponding to the first data value.

3. The memory controller of claim 1 or 2, wherein the instructions, when executed by the one or more processors individually or collectively, further cause the memory controller to:
based on the command comprising a read request to read a first data value from among the data values, generate a first latent data representation from among the latent data representations by decompressing a first compressed data value from among compressed data values of the latent data representations, based on a first distribution parameter from among the distribution parameters and corresponding to the first data value.

4. The memory controller of claim 3, wherein the instructions, when executed by the one or more processors individually or collectively, further cause the memory controller to:
generate the first data value corresponding to the first latent data representation by using the invertible neural network model.

5. The memory controller of claim 3 or 4, wherein the distribution parameters are stored in the memory space,
wherein the read request comprises a first index value indicating the first data value, and
wherein the instructions, when executed by the one or more processors individually or collectively, further cause the memory controller to select the first distribution parameter from among the distribution parameters based on the first index value.

6. The memory controller of any one of claims 1-5, wherein the instructions, when executed by the one or more processors individually or collectively, further cause the memory controller to:
generate the latent data representations by performing domain conversion such that an entropy of the data values is reduced, by using the invertible neural network model; and/or
perform entropy coding on the latent data representations based on the distribution parameters.

7. The memory controller of any one of claims 1-6, wherein the instructions, when executed by the one or more processors individually or collectively, further cause the memory controller to:
generate a merged latent data representation by reshaping the latent data representations; and
generate respective distribution parameters of the latent data representations based on a distribution of the merged latent data representation.

8. The memory controller of any one of claims 1-7, wherein the invertible neural network model comprises a normalizing flow; and/or wherein the non-invertible neural network model comprises a variational autoencoder, VAE.

9. An operating method of a memory controller, the operating method comprising:
generating latent data representations corresponding to data values to be written in a memory space by using an invertible neural network model;
generating distribution parameters corresponding to the latent data representations by using a non-invertible neural network model;
compressing the latent data representations based on the distribution parameters;
partially decompressing at least one latent data representation from among the compressed latent data representations corresponding to at least one data value from among the data values written in the memory space, based on a command from a host device to provide the at least one data value; and
provide, to the host device, the at least one data value.

10. The operating method of claim 9, further comprising:
based on the command comprising a read request to read a first data value from among the data values, generating the first data value from a first compressed data value from among compressed data values of the latent data representations by using a first distribution parameter from among the distribution parameters and corresponding to the first data value.

11. The operating method of claim 9 or 10, further comprising:
based on the command comprising a read request to read a first data value from among the data values, generating a first latent data representation from among the latent data representations by decompressing a first compressed data value from among compressed data values of the latent data representations, based on a first distribution parameter from among the distribution parameters and corresponding to the first data value.

12. The operating method of claim 11, further comprising:
generating the first data value corresponding to the first latent data representation by using the invertible neural network model.

13. The operating method of claim 11 or 12, wherein the distribution parameters are stored in the memory space,
wherein the read request comprises a first index value indicating the first data value, and wherein the operating method further comprises selecting the first distribution parameter from among the distribution parameters based on the first index value.

14. The operating method of any one of claims 9-13, wherein the generating of the latent data representations comprises:
generating the latent data representations by performing domain conversion such that an entropy of the data values is reduced, by using the invertible neural network model.

15. The operating method of any one of claims 9-14, wherein the latent data representations are reshaped to generate merged latent data representations, and
wherein the generating of the distribution parameters comprises generating respective distribution parameters of the latent data representations based on a distribution of the merged latent data representations.
